Europäisches Patentamt

European Patent Office

Office européen des brevets

(11) Veröffentlichungsnummer: **0 433 721 A2**

## (12) EUROPÄISCHE PATENTANMELDUNG

(21) Anmeldenummer: 90122756.1

(22) Anmeldetag: 28.11.90

(51) Int. Cl.5: **H05K 3/34**

(30) Priorität: 22.12.89 DE 3942741

(43) Veröffentlichungstag der Anmeldung:
26.06.91 Patentblatt 91/26

(84) Benannte Vertragsstaaten:
AT BE CH DE FR GB IT LI NL SE

(71) Anmelder: Siemens Aktiengesellschaft
Wittelsbacherplatz 2
W-8000 München 2(DE)

(72) Erfinder: Schmidt, Hans-Fr., Dr.

Graf Tattenbachweg 3b
W-8191 Eurasburg(DE)
Erfinder: Hadwiger, Helmut
Friedrich-Herschel-Strasse 5
W-8000 München 80(DE)
Erfinder: Prochazka, Milan
Beblostrasse 15
W-8000 München 80(DE)
Erfinder: Roelants, Eddy, Dr.
P. Ascanusstrasse 31
B-1700 Asse(BE)

(54) Verfahren zum Aufbringen von Lötstoppabdeckungen auf Leiterplatten.

(57) Auf die Leiterplatte werden nacheinander ganzflächig ein lichtempfindlicher negativ arbeitender Lötstopplack (5) und eine lichtempfindliche Schicht eines fotografischen Materials auf Silberhalogenidbasis oder ein negativ arbeitendes Fotoresist aufgebracht. Durch selektive Belichtung im Bereich von Durchkontaktierungen (3) und/oder Lötpads (4) wird dort eine Maske (600) gebildet, welche die Durchkontaktierungen (3) und/oder Lötpads (4) beim nachfolgenden Belichten des Lötstopplacks (5) abschirmt.

Nach dem vorzugsweise mit Flutlicht (F) vorgenommenen selektiven Belichten des Lötstopplacks (5) brauchen dann nur noch die Maske (600) und die darunterliegenden unbelichteten Bereiche des Lötstopplacks (5) entfernt werden. Das erfindungsgemäße Verfahren ist insbesondere für das Aufbringen, einer Lötstoppabdeckung auf dreidimensionale Leiterplatten geeignet, da hier herkömmliche Maskentechniken zur Strukturierung des Lötstopplacks nicht anwendbar sind.

FIG 5

EP 0 433 721 A2

## VERFAHREN ZUM AUFBRINGEN EINER LÖTSTOPPABDECKUNG AUF LEITERPLATTEN

Die Erfindung betrifft ein Verfahren zum Aufbringen einer Lötstoppabdeckung auf das Leiterbild von Leiterplatten, inbesondere von dreidimensionalen Leiterplatten, unter Freilassung von Durchkontaktierungen und/oder Lötpads.

Bei der Herstellung von Leiterplatten soll nach der Strukturierung des Leiterbildes auf diejenigen Bereiche des Leiterbildes die keine Lötverbindung eingehen sollen eine Lötstoppabdeckung aufgebracht werden. Diese Lötstoppabdeckung läßt nur Durchkontaktierungen und/oder Lötpads frei, so daß dort dann durch Heißverzinnen oder durch einen Umschmelzvorgang eine lötfähige Endoberfläche erzeugt werden kann. Das Aufbringen der Lötstoppabdeckung kann dabei durch selektives Auftragen eines Lötstopplackes auf die zu schützenden Bereiche oder durch ganzflächiges Auftragen eines lichtempfindlichen Lötstopplackes mit anschließender Fotostrukturierung vorgenommen werden. Das selektive Auftragen ist dabei mit einem zu großen Aufwand verbunden, während die Fotostrukturierung insbesondere bei dreidimensionalen Leiterplatten mit herkömmlichen Maskentechniken nicht durchführbar ist.

Der Erfindung liegt die Aufgabe zugrunde ein wirtschaftliches Verfahren zum Aufbringen einer Lötstoppabdeckung auf Leiterplatten zu schaffen, das auch bei dreidimensionalen Leiterplatten anwendbar ist.

Die Lösung dieser Aufgabe erfolgt durch folgende Verfahrensschritte:

a) auf die Leiterplatte wird ganzflächig ein lichtempfindlicher negativ arbeitender Lötstopplack aufgebracht;

b, auf den Lötstopplack wird im Bereich der Durchkontaktierungen und/oder Lötpads eine Maske aufgebracht;

c) die nicht von der Maske abgedeckten Bereiche des Lötstopplacks werden belichtet;

d) die Maske und die darunterliegenden unbelichteten Bereiche des Lötstopplacks werden entfernt.

Bei dem erfindungsgemäßen Verfahren wird also auf den Lötstopplack eine Maske aufgebracht, mit deren Hilfe die Fotostrukturierung des Lötstopplacks auch bei dreidimensionalen Leiterplatten auf einfache Weise durchgeführt werden kann. Bei der Herstellung dieser Maske kann auf bewährte Techniken zurückgegriffen werden, die auch bei dreidimensionalen Leiterplatten problemlos durchgeführt werden können.

Gemäß einer ersten bevorzugten Ausführungsform des erfindungsgemäßen Verfahrens wird zur Herstellung der Maske auf den Lötstopplack ganzflächig eine lichtempfindliche Schicht eines fotographischen Materials auf Silberhalogenidbasis aufgebracht und im Bereich der Durchkontaktierungen und/oder Lötpads selektiv belichtet und entwickelt, worauf dann die unbelichteten Bereiche der lichtempfindlichen Schicht entfernt oder durch Herauswaschen des unbelichteten Silberhalogenids fixiert werden. Bei dieser Ausführungsform werden also durch die selektive Belichtung und Entwicklung des fotographischen Materials im Bereich der Durchkontaktierungen und/oder Lötpads die Silberionen zu Silber reduziert, so daß nach dem Entfernen des nicht reduzierten Silberhalogenids beim Fixieren eine exakte Maske aus Silber verbleibt, mit deren Hilfe die Fotostrukturierung des Lötstopplacks durchgeführt wird. Dabei ist insbesondere hervorzuheben, daß auch im kritischen Innenbereich der Durchkontaktierungen auf Grund der extrem hohen Lichtempfindlichkeit der Silberhalogenide die erforderliche Schwärzung des fotographischen Materials durch Belichtung und Entwicklung bzw. Reduktion möglich ist.

Gemäß einer zweiten Ausführungsform des erfindungsgemäßen Verfahrens ist vorgesehen, daß zur Herstellung der Maske auf den Lötstopplack ganzflächig ein negativ arbeitendes Fotoresist aufgebracht und im Bereich von Durchkontaktierungen und/oder Lötpads selektiv belichtet und entwickelt wird. Die Nachteile der Fotostrukturierung lichtempfindlicher Lötstopplacke werden hier also durch die Verwendung eines herkömmlichen negativ arbeitenden Fotoresists umgangen.

Gemäß einer bevorzugten Ausgestaltung der ersten Ausführungsform des erfindungsgemäßen Verfahrens wird eine lichtempfindliche Schicht verwendet, deren Empfindlichkeitsspektrum bei größeren Wellenlängen liegt als das Empfindlichkeitsspektrum des darunter liegenden Lötstopplackes. Hierdurch kann eine unerwünschte Belichtung des Lötstopplackes bei der Herstellung der Maske mit Sicherheit ausgeschlossen werden. Die selektive Belichtung der lichtempfindlichen Schicht im Bereich der Durchkontaktierungen und/oder Lötpads wird dabei vorzugsweise mit Hilfe eines Lasers, insbesondere eines Ar-Lasers, vorgenommen. Die Laserstrahlen können dabei insbesondere gezielt in die Durchkontaktierungslöcher gerichtet werden und dort für eine einwandfreie Belichtung des fotographischen Materials sorgen.

Weiterhin hat es sich bei der ersten Ausführungsform des erfindungsgemäßen Verfahrens als besonders günstig erwiesen wenn die belichteten Bereiche der lichtempfindlichen Schicht durch Auflösen der als Bindemittel verwendeten Gelatine entfernt werden. Derartige Lösungsvorgänge zur Entfernung der aus Silber bestehenden Maske können besonders wirtschaftlich durchgeführt werden.

Gemäß einer bevorzugten Ausgestaltung der zweiten Ausführungsform des erfindungsgemäßen Verfahrens wird ein negativ arbeitendes Fotoresist verwendet, dessen Empfindlichkeitsspektrum bei größeren Wellenlängen liegt als das Empfindlichkeitsspektrum des darunterliegenden Lötstopplakkes. Hierdurch kann auch in diesem Falle eine unerwünschte Belichtung des Lötstopplackes bei der Herstellung der Maske mit Sicherheit ausgeschlossen werden. Die selektive Belichtung des negativ arbeitenden Fotoresists im Bereich der Durchkontaktierungen und/oder Lötpads wird dann auch in diesem Falle vorzugsweise mit Hilfe eines Lasers, insbesondere mit Hilfe eines Ar-Lasers, vorgenommen. Auch hier können die Laserstrahlen dann wieder gezielt in die Durchkontaktierungslöcher gerichtet werden und dort für eine einwandfreie Belichtung des negativ arbeitenden Fotoresists sorgen.

Beim Einsatz eines Lasers sollte die Bewegung des Laserstrahls relativ zur Leiterplatte vorzugsweise frei programmierbar sein, d.h. die Umschreibung und Belichtung von Durchkontaktierungen und/oder Lötpads kann dann auf besonders einfache Weise vorgenommen werden.

Gemäß einer weiteren bevorzugten Ausgestaltung des erfindungsgemäßen Verfahrens wird die Belichtung des Lötstopplackes im Schritt c) durch Flutlicht vorgenommen. Eine derartige Belichtung durch Fluchtlicht erfordert einen besonders geringen Aufwand. Als Fluchtlicht hat sich dabei insbesondere UV-Strahlung bewährt, die eine einwandfreie Belichtung der herkömmlichen fotostrukturierbaren Lötstopplacke ermöglicht.

Die Vorteile des erfindungsgemäßen Verfahrens kommen insbesondere dann zum Tragen, wenn der Lötstopplack auf eine Leiterplatte mit einem dreidimensionalen, spritzgegossenen Substrat und eingespritzten Durchkontaktierungslöchern aufgebracht wird.

Ausführungsbeispiele der Erfindung sind in der Zeichnung dargestellt und werden im folgenden näher beschrieben.

Es zeigen

Fig. 1 bis 7    in stark vereinfachter schematischer Darstellung die verschiedenen Verfahrensstadien einer ersten Ausführungsform des erfindungsgemäßen Verfahrens zum Aufbringen einer Lötstoppabdeckung auf Leiterplatten und

Fig. 8    bis 14 in stark vereinfachter schematischer Darstellung die verschiedenen Verfahrensstadien einer zweiten Ausführungsform des erfindungsgemäßen Verfahrens zum Aubringen einer Lötstoppabdeckung auf Leiterplatten.

Vor der detaillierten Beschreibung ist noch darauf hinzuweisen, daß der Begriff "Leiterplatte" und auch die vereinfachte Zeichnung zunächst auf ein flächiges Gebilde schließen lassen. Die Vorteile des erfindungsgemäßen Verfahrens ohne Fotostrukturierungen mittels der üblichen Maskentechniken beim Aufbringen des Lötstopplacks sind jedoch genau darin zu sehen, daß von der ebenen Form abgewichen werden kann und dreidimensionale Leiterplatten mit beliebigen abgewinkelten oder gekrümmten Formen mit einer Lötstoppabdeckung versehen werden können.

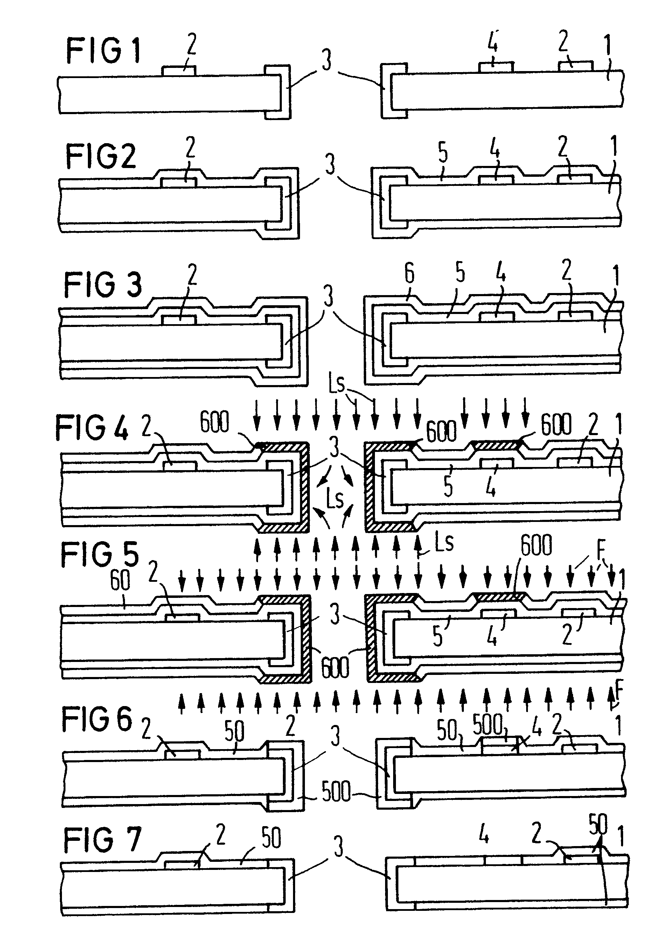

Zur Erläuterung der ersten Ausführungsform des erfindungsgemäßen Verfahrens wird zunächst auf Fig. 1 verwiesen, die einen Schnitt durch einen Teil einen Leiterplatte zeigt, auf deren elektrisch isolierendes Substrat 1 als Leiterbild Leiterbahnen 2, Durchtkontaktierungen 3 und Lötpads 4 aufgebracht wurden. Bei dem dargestellten Substrat 1 handelt es sich um ein spritzgegossenens Basismaterial mit eingespritzten Löchern für die Durchkontaktierungen 3. Als Material für ein derartiges Substrat 1 ist beispielsweise glasfaserverstärktes Polyetherimid geeignet.

Zum Aufbringen einer Lötstopppabdeckung auf das Leiterbild der in Fig. 1 ausschnittsweise dargestellten Leiteprlatte unter Freilassung von Duchkontaktierungen 3 und Lötpads 4 wird nun zunächst gemäß Fig. 2 ganzflächig durch Tauchen oder durch elektrostatisches Sprühen ein lichtempfindlicher Lötstopplack 5 aufgebracht. Bei diesem Lötstopplack 5, der beispielsweise mit einer Stärke zwischen 20 und 30 Mikrometern aufgebracht wird, handelt es sich um einen sogenannten Negativ-Lack, d.h. die belichteten Bereiche werden unlöslich, während die unbelichteten Bereiche beim Entwickeln entfernt werden. Ein geeigenter Lötstopplack 5 wird beispielsweise von der Fa. Peters D-4152 Kempen unter dem Handelsnamen ELPEMER ES 2469 SM vertrieben. Die Spektralempfindlichkeit dieses Lötstopplacks liegt im Wellenlängenbereich von 350 bis 400 nm.

Nach dem Aufbringen des Lötstopplacks 5 wird gemäß Fig. 3 ganzflächig durch Tauchen oder Spritzen eine lichtempfindliche Schicht 6 eines fotographischen Materials auf Silberhalogenidbasis aufgebracht. Bei diesem fotographischen Material handelt es sich um eine in der Fotografie übliche Silberhalogenidemulsion mit Silberchlorid- und/oder Silberbromid- und/oder Silberjodidkörnern in Gelatine.

Gemäß Fig. 4 wird anschließend die lichtempfindliche Schicht 6 im Bereich der Durchkontaktierungen 3 und der Lötpads 4 mit Hilfe eines Lasers in einem Scan-Verfahren belichtet, wobei die Laserstrahlung durch Pfeile Ls lediglich angedeutet ist. Die Pfeile im Innenbereich der Durchkontaktierung sollen aufzeigen, daß die Belichtung der Schicht 6 im Bereich der Lochwandung durch einen schrägen Einfall der Laserstrahlen Ls verbessert werden kann. Zur Erzeugung der Laserstrahlen Ls können beispielsweise frequenzverdoppelte Nd: YAG-Laser oder vorzugsweise Ar-Ionenlaser eingesetzt werden. Mit derartigen Lasern wird mit Sicherheit ausgeschlosssen, daß der darunterliegende UV-empfindliche Lötstopplack 5 mitbelichtet wird.

Das bei der Belichtung gemäß Fig. 4 in der lichtempfindlichen Schicht 6 im Bereich der Durchkontaktierungen 3 und Lötpads 4 erzeugte latente Bild wird durch Entwickler in Form einer Schwärzung sichtbar gemacht. Die belichteten und entwickelten Bereiche 600 der lichtempfindlichen Schicht 6 sind in Fig. 4 ebenfalls durch eine Schwärzung hervorgehoben. Bei der Entwicklung werden die durch die vorhergehende Belichtung gebildeten Silberionen zu Silber reduziert, wobei die Reduktion an den Stellen einsetzt, wo sich latent Bildkeime befinden. Geeignete Entwickler bestehen im wesentlichen aus alkalischen wäßrigen Lösungen eines Reduktionsmittels, wobei als Reduktionsmittel beispielsweise Hydrochinon, Brenzcatechin und allgemein aromatische Aminoalkohole oder Diamine geeignet sind. Zusatz von Natriumsulfid verringert die Luftoxidation der gelösten Reduktionsmittel und fängt bei der Entwicklung gebildete Oxidationsprodukte ab.

Nach beendeter Entwicklung werden gemäß Fig. 5 die nichtbelichteten Bereiche der lichtempfindlichen Schicht 6 lichtbeständig gemacht. Bei diesem als Fixieren bezeichneten Vorgang wird das nicht reduzierte Silberhalogenid beispielsweise durch Baden in einer Natriumthiosulfatlösung herausgewaschen, so daß hier eine für Licht durchlässige Gelatineschicht 60 verbleibt. Die belichteten für lichtundurchlässigen Bereiche 600 sind dann eine im wesentlichen aus Silber bestehende metallische Maske. Diese Maske 600 schirmt bei der in Fig. 5 erkennbaren Belichtung des Lötstopplackes 5 mit Flutlicht F die darunterliegenden Bereiche ab . Als Flutlicht F wird vorzugsweise UV-Strahlung verwendet.

Nach der vorstehend geschilderten selektiven Belichtung des Lötstopplackes 5 werden gemäß Fig. 6 die verbliebenen, d. h. die belichteten Bereiche 600 der lichtempfindlichen Schicht 6 entfernt. Bei diesem Strippen der Maske 600 wird das Silber in einer geeigneten Ätzlösung, beispielsweise in Salpetersäure aufgelöst. Noch einfacher ist es jedoch die Maske 600 durch Auflösen der als Bindemittel verwendeten Gelatine zu entfernen. Bei diesem Schritt wird dann auch gleichzeitig die Gelatineschicht 60 aufgelöst. Während die belichteten Bereiche des Lötstopplacks 5 in Fig. 6 mit der Bezugsziffer 50 gekennzeichnet sind, sind die durch das Entfernen der Maske 600 freigelegten unbelichteten Bereiche des Lötstopplacks 5 mit der Bezugsziffer 500 versehen.

Nach dem Entfernen der Maske 600 gemäß Fig. 6 werden die unbelichteten Bereich 500 des Lötstopplacks 5 durch Eintauchen der gesamten Leiterplatte in eine handelsübliche Entwicklerlösung entwickelt und dadurch vollständig entfernt. Gemäß Fig. 7 verbleiben somit nur noch die belichteten Bereiche 50 des: Lötstopplacks5, welche mit Ausnahme der Durchkontaktierungen 3 und der Lötpads 4 sämtliche Bereiche der Leiterplatte und insbesondere die Leiterbahnen 2 vollständig abdekken. Durch anschließendes Heißverzinnen können die Durchkontaktierungen 3 und die Lötpads problemlos selektiv mit einer Zinn-Blei-Legierung überzogen werden. Wenn bereits vor dem ganzflächigen Aufbringen des Lötstopplackes 5 auf die Leiterplatte auf deren Leiterbahnen 2, Durchkontaktierungen 3 und Lötpads 4 eine Endoberfläche durch galvanische Abscheidung von Zinn oder einer Zinn-Blei-Legierung aufgebracht worden ist, so ist nur noch ein Umschmelzprozeß zur Verbesserung der Lötbarkeit im Bereich der Durchkontaktierungen 3 und Lötpads 4 erforderlich.

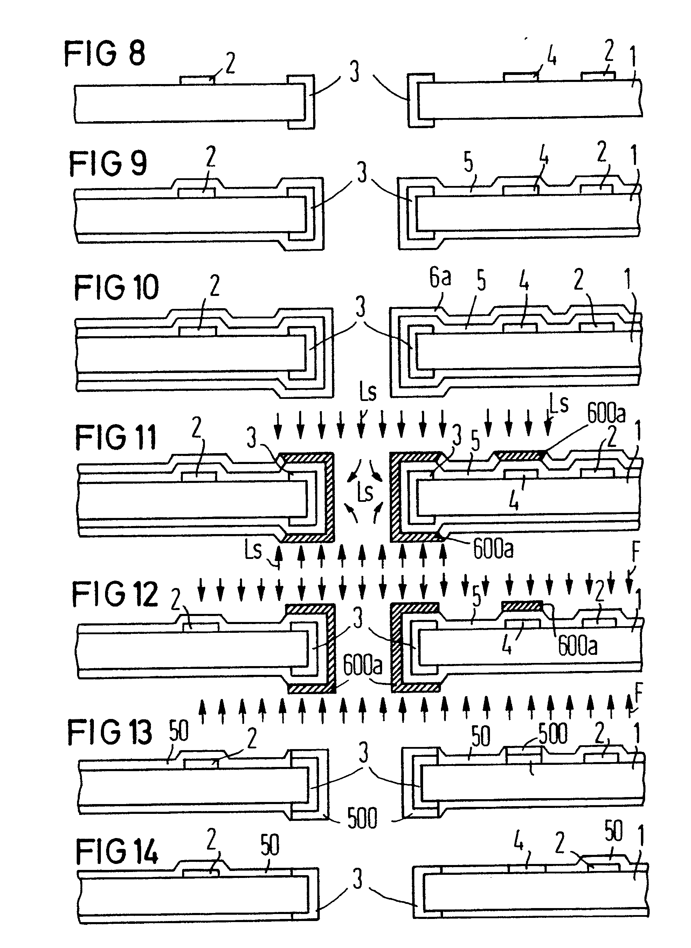

Bei der zweiten Ausführungsform des erfindungsgemäßen Verfahrens wird gemäß Fig. 8 wieder von einer Leiterplatte ausgegangen, auf deren elektrisch isolierendes Substrat 1 als Leiterbild Leiterbahnen 2, Durchkontaktierungen 3 und Lötpads 4 aufgebracht wurden.

Zum Aufbringen einer Lötstoppabdeckung auf das Leiterbild der in Fig. 8 ausschnittsweise dargestellten Leiterplatte unter Freilassung von Durchkontaktierungen 3 und Lötpads 4 wird nun zunächst gemäß Fig. 9 ganzflächig durch Tauchen oder durch elektrostatisches Sprühen ein lichtempfindlicher Lötstopplack 5 aufgebracht. Bei diesem Lötstopplack 5 handelt es sich wieder um den bei der ersten Ausführungsform verwendeten Negativ-Lack.

Nach dem Aufbringen des Lötstopplacks 5 wird gemäß Fig. 10 ganzflächig durch Tauchen, Spritzen oder dergleichen ein negativ arbeitendes Fotoresist 6a aufgebracht. Bei diesem Fotoresist 6a handelt es sich um ein handelsübliches Produkt, welches durch Vernetzung oder Fotopolymerisation schwer löslich bis unlöslich wird. Derartige negativ arbeitende Fotoresists werden beispielsweise bei der Herstellung von Leiterplatten eingesetzt. Geeignet ist beispielsweise ein negativ arbeitendes Fotoresist welches außerhalb des UV-Spektrums mit einem Ar-Laser bei Wellenlängen von 488 nm belichtet werden kann.

Gemäß Fig. 11 wird anschließend das negativ arbeitende Fotoresist 6a im Bereich der Durchkontaktierungen 3 und der Lötpads 4 mit Hilfe eines Lasers in einem Scan-Verfahren belichtet, wobei die Laserstrahlung durch Pfeile Ls lediglich angedeutet ist. Die Pfeile im Innenbereich der Durchkontaktierung sollen aufzeigen, daß die Belichtung des Fotoresists 6a im Bereich der Lochwandung durch einen schrägen Einfall der Laserstrahlen Ls verbessert werden kann. Zur Erzeugung der Laserstrahlen Ls können beispielsweise Ar-Ionenlaser eingesetzt werden. Mit derartigen Lasern wird mit Sicherheit ausgeschlossen, daß der darunterliegende UV-empfindliche Lötstopplack 5 mitbelichtet wird. Die belichteten Bereiche des Fotoresists 6a bilden eine Maske, die in Fig. 11 durch eine Schwärzung hervorgehoben und mit der Bezugsziffer 600 a gekennzeichnet ist.

Gemäß Fig. 12 werden die unbelichteten und damit löslichen bereiche des Fotoresists 6a entfernt. Diese Entfernung der unbelichteten Bereiche des Fotoresists 6a wird unter Verwendung eines üblichen Entwicklers durchgeführt.

Fig. 12 zeigt ferner, daß die Maske 600 a bei der Belichtung des Lötstopplacks 5 mit Flutlicht F die darunterliegenden Bereiche abschirmt. Als Flutlicht F wird auch hier wieder vorzugsweise UV-Strahlung verwendet.

Nach der vorstehend geschilderten selektiven Belichtung des Lötstopplacks 5 wird gemäß FiG. 13 die Maske 600 a entfernt. Das Entfernen der den belichteten Bereichen des Fotoresists 6a entsprechenden Maske 600 a wird dabei in einem handelsüblichen Stripper vorgenommen.

Nach dem Entfernen der Maske 600 a werden wie bei der ersten Ausführungsform des erfindungsgemäßen Verfahrens die unbelichteten Bereiche 500 des Lötstopplacks 5 durch Eintauchen in eine Entwicklerlösung entwickelt und dadurch vollständig entfernt.

Gemäß Fig. 14 verbleiben somit nur noch die belichteten Bereiche 50 des Lötstopplacks 5, welche mit Ausnahme der Durchkontaktierungen 3 und der Lötpads 4 sämtliche Bereiche der Leiterplatte und insbesondere die Leiterbahnen 2 vollständig abdecken. Eine lötfähige Endoberfläche im Bereich der Durchkontaktierungen 3 und Lötpads 4 kann dann auch in diesem Fall durch Heißverzinnen oder durch einen Umschmelzvorgang erzeugt werden.

## Ansprüche

1. Verfahren zum Aufbringen einer Lötstoppabdeckung auf das Leiterbild von Leiterplatten, insbesondere von dreidimensionalen Leiterplatten, unter Freilassung von Durchkontaktierungen und/oder Lötpads, mit folgenden Verfahrensschritten:

   a) auf die Leiterplatte wird ganzflächig ein lichtempfindlicher negativ arbeitender Lötstopplack (5) aufgebracht;

   b) auf den Lötstopplack (5) wird im Bereich der Durchkontaktierungen (3) und/oder Lötpads (4) eine Maske (600;600 a) aufgebracht;

   c) die nicht von der Maske (600, 600 a) abgedeckten Bereiche des Lötstopplacks (5) werden belichtet;

   d) die Maske (600, 600 a) und die darunterliegenden unbelichteten Bereiche (500) des Lötstopplacks (5) werden entfernt.

2. Verfahren nach Anspruch 1,
dadurch gekennzeichnet,
daß zur Herstellung der Maske (600) auf den Lötstopplack (5) ganzflächig eine lichtempfindliche Schicht (6) eines fotografischen Materials auf Sitberhalogenidbasis aufgebracht und im Bereich der Durchkontakierungen (3) und/oder Lötpads (4) selektiv belichtet und entwickelt wird und daß dann die unbelichteten Bereiche der lichtempfindlichen Schicht (6) entfernt oder durch Herauswaschen des unbelichteten Silberhalogenids fixiert werden.

3. Verfahren nach Anspruch 1,
dadurch gekennzeichnet,
daß zur Herstellung der Maske (600 a) auf den Lötstopplack (5) ganzflächig ein negativ arbeitendes Fotoresist (6a) aufgebracht und im Bereich von Durchkontaktierungen (3) und/oder Lötpads (4) selektiv belichtet und entwickelt wird.

4. Verfahren nach Anspruch 2,
dadurch gekennzeichnet, daß eine lichtempfindliche Schicht (6) verwendet wird, deren Empfindlichkeitsspektren bei größeren Wellenlängen liegt als das Empfindlichkeitsspektrum des darunterliegenden Lötstopplacks (5).

5. Verfahren nach Anspruch 2 oder 4,
dadurch gekennzeichnet,
daß die selektive Belichtung der lichtempfindlichen Schicht (6) im Bereich der Durchkontaktierungen und/oder Lötpads (4) mit Hilfe eines Lasers vorgenommen wird.

6. Verfahren nach Anspruch 5,
dadurch gekennzeichnet,
daß die selektive Belichtung der lichtempfindlichen Schicht (6) mit Hilfe eines Ar-Lasers vorgenommen wird.

7. Verfahren nach einem der Ansprüche 2, 4, 5 oder 6,
dadurch gekennzeichnet,
daß die belichteten Bereiche (600) der lichtempfindlichen Schicht (6) durch Auflösen der als Bindemittel verwendeten Gelatine entfernt werden.

8. Verfahren nach Anspruch 3,
dadurch gekennzeichnet,
daß ein negativ arbeitendes Fotoresist (6a) verwendet wird, dessen Empfindlichkeitsspektrun
bei größeren Wellenlängen liegt als das Empfindlichkeitsspektrum des darunterliegenden
Lötstopplackes (5).

9. Verfahren nach Anspruch 3 oder 8,
dadurch gekennzeichnet,
daß die selektive Belichtung des negativ arbeitenden Fotoresists (6a) im Bereich der Durchkontaktierungen und/oder Lötpads (4) mit Hilfe
eines Lasers vorgenommen wird.

10. Verfahren nach Anspruch 9,
dadurch gekennzeichnet,
daß die selektive Belichtung des negativ arbeitenden Fotoresists (6a) mit Hilfe eines Ar-Lasers vorgenommen wird.

11. Verfahren nach einem der Ansprüche 5, 6, 9
oder 10,
dadurch gekennzeichnet,
daß die Bewegung des Laserstrahls (Ls) relativ
zur Leiterplatte frei programmierbar ist.

12. Verfahren nach einem der vorhergehenden Ansprüche,
dadurch gekennzeichnet,
daß die Belichtung des Lötstopplackes (5) im
Schritt c) durch Flutlicht (F) vorgenommen
wird.

13. Verfahren nach Anspruch 12,
dadurch gekennzeichnet,
daß als Flutlicht (F) UV-Strahlung verwendet
wird.

14. Verfahren nach einem der vorhergehenden Ansprüche,
dadurch gekennzeichnet,
daß der Lötstopplack (4) auf eine Leiterplatte
mit einem dreidimensionalen spritzgegossenen
Substrat (1) und eingespritzten Durchkontaktierungslöchern aufgebracht wird.

FIG 1

FIG2

FIG 3

FIG 4

FIG 5

FIG 6

FIG 7

FIG 8

FIG 9

FIG 10

FIG 11

FIG 12

FIG 13

FIG 14